# EUROPEAN PATENT SPECIFICATION

(11) **EP 2 441 096 B1**
(45) Date of publication and mention of the grant of the patent: **30.03.2016**
(21) Application number: 10733036.7
(22) Date of filing: 07.06.2010
(51) Int. Cl.: H01L 31/18, B32B 37/00, B32B 17/10

(54) **METHOD FOR PRODUCING A SOLAR PANEL**
VERFAHREN ZUR HERSTELLUNG EINES SOLARMODULS
PROCÉDÉ DE FABRICATION D'UN PANNEAU SOLAIRE

(30) Priority: 08.06.2009 AT 8852009; 08.06.2009 AT 8862009; 25.02.2010 CH 250102010
(43) Date of publication of application: 18.04.2012
(60) Divisional application: 15184563.3
(73) Proprietor: 3S Swiss Solar Systems AG, 3250 Lyss (CH)
(72) Inventor: ZAHND, Jürg, CH-3427 Utzenstorf (CH); LANGE, Ronald F. M., CH-3073 Gümligen (CH); GMÜR, Markus, CH- 2502 Biel (CH); POLO, Roman, CH 3006 Bern (CH)
(74) Representative: Patentbüro Paul Rosenich AG
(86) International application number: PCT/IB2010/052511
(87) International publication number: WO 2010/143117

(56) References cited:
- EP-A1- 1 900 516
- WO-A1-2005/098522
- WO-A2-2008/048464
- WO-A2-2009/114189
- DE-A1- 3 300 622
- DE-A1- 10 048 974
- JP-A- 2001 051 284
- JP-A- 2001 148 488
- JP-A- 2003 204 073
- JP-A- 2006 088 511
- US-B1- 6 369 316

## Description

### FIELD OF THE INVENTION

The present invention relates generally to producing solar panels, and more particularly, to a method and apparatus for producing a solar panel built up of layers in a simple, robust, cost effective, secure, efficient, and environmental friendly manner.

### BACKGROUND OF THE INVENTION

In the manufacture of solar panels, normally a sandwich build up (also referred to as sandwiched bodies or lay-up of solar modules or photovoltaic modules) is built essentially at normal room conditions. This sandwich build up comprises a glass plate as base plate. A first layer of plastic foil is placed on the base plate on which a network of solar cells is placed and the solar cells are covered by a second layer of plastic foil on which a cover layer is laid. The first and second layer of plastic (encapsulant) between which the solar cells are embedded, can for example, be an EVA foil. The cover layer, also called 'back sheet' can form a weather resistant and non-transparent layer in the visible spectral range of plastic, for example, a PVDF-PET-PVDF laminate. After manual construction of the sandwich build up, it will be processed in a laminator. The laminator usually incorporates a base with a heating plate and an upper portion with a pressure membrane and is thus essentially a heating / cooling press. The pressure membrane has a dual function. First, it serves to complete the processing chamber airtight. Second, it exerts a predetermined pressure on the layers of the solar module to be connected. The space between the plate and pressure membrane can usually be evacuated. The sandwich build up is placed in the laminator with the glass plate on the under side, so that it is heated by the heating plate. The glass plate is heated during the lamination process to a required temperature to ensure a good curing within the EVA foil and good connecting with the glass plate and the photovoltaic elements. The photovoltaic elements can be of any known type such as crystalline, thin film, hetero junction, etc. Foils are not the only way of providing layers to the module: foils may be curtain coated or sprayed on as well.

The prior art discloses numerous techniques for laminating sandwiched build up. During the lamination of sandwiched build up, an interconnecting process takes place under the influence of heat and pressure in which the solar cells are encapsulated between the covering glass plate and the back sheet. With direct contact to the heating plate, the glass plate can warp upward or down-ward (dishing), so that is a non-uniform temperature distribution in the sandwich build up. The temperature at the edges of the glass plate may be higher or lower than in the middle depending on curvature of the glass plate. Due to the resulting gap between the edges or the middle of the glass plate and the heating plate, the heating process delays, since it takes a long time until the glass and other layers have reached the temperature needed in the areas that are not in contact with the heating plate. To prevent warping of the glass plate, the sandwich build up may therefore be positioned on pins protruding from the heating plate, so that a slower more uniform heating of the module can be achieved.

According to the state of the art, once the sandwich build up has reached its melting temperature, which (depending on glass thickness and sandwich build up) is the case after about 7 minutes, pressure is applied from above in order to achieve a good energy transfer, a good EVA curing and a good interconnection of the layers. The pressing process now taking place at a pressure of about 1 bar, which also takes 7 minutes. The pressing process may takes place under under-pressure or vacuum in the processing chamber of the laminator to avoid formation of gas bubbles inside the layup. During the pressing process, the glass plate is heated further. The heating and pressing process taking place in the laminator is called lamination. During lamination, when, for example EVA foil is used, the milky EVA foil is turned into a clear, three-dimensionally cross-linked and no longer meltable transparent plastic layer in which the solar cells are now embedded and which is firmly connected to the glass plate and the back sheet. After pressing, the sandwich structure is cooled in a cooling press under pressure Further, disadvantages of the prior art includes the long residence time needed for the necessary heating of the glass plate of the sandwich build up in the laminator. This results in relatively long throughput times and,a strong restriction on the number of solar panels producible with laminator. In principle, the residence time maybe reduced by heating the glass plate prior to construction of the sandwich and the insertion into the laminator. However, consideration of heating of the glass plate prior to construction of the sandwich, were always rejected, as the foils used for encapsulation such as EVA foils, may melt and form bubbles and the EVA foil may no longer be handled because it becomes too soft. [005] The features of the prior art disclose complex design and bulky structural indices that hinder their performance. However, no such means is available in the commercial market at the present time which is capable of achieving increased efficiency and productivity for producing solar panels in a simple, robust, cost effective, secure, and environmental friendly manner.
The JP2003204073 discloses preheating of FRP substrate to prevent the occurrence of bubbling at the time of sticking the EVA film.
JP 2001148488 dicloses a bonding apparatus for solar cells wherein a pressfitting operation is executed under vaccuum.

Therefore, the present scenario is necessitating the need for an improved combination of convenience and utility which is capable of overcoming disadvantages inherent in existing sandwiched build up laminating systems and providing means for: achieving increased efficiency and productivity for producing solar panels in a simple, robust, cost effective, secure, and environmental friendly manner.

### SUMMARY OF THE INVENTION

In view of the foregoing disadvantages inherent in the prior arts, the general purpose of the present invention is to provide an improved combination of convenience and utility, to include the advantages of the prior art, and to overcome the drawbacks inherent in the prior art. The present invention incorporating within it simple structural indices for a simple, cost effective, secure, robust, reliable, and environment friendly operation.

An object of the present invention is, therefore, to increase the efficiency and productivity achieved with a laminator.

In one aspect, the present invention provides a method for producing a solar panel built up of a plurality of layers, wherein at least one layer is pre-heated and put together under vacuum or gas atmosphere with at least one other layer according to claim 1.

In another aspect, the present invention provides a device according to claim 6 for the production of solar modules, wherein a first side wall and a second side wall of a working chamber are movable relative to each other. A seal, preferably an elastic seal, may be provided between the side walls of the working chamber so that in a first relative position the working chamber is closed and may be evacuated or a gas atmosphere may be established therein. As the side walls of the working chamber move to a second relative position, materials inside the working chamber may be brought in contact with each other. The device may have processing chamber that may be evacuated and / or be filled with a gas. Means for holding the base plate are provided with means for controlling the temperature in the working chamber. The movable support is capable of moving in a direction of the sidewall.

These together with other objects of the invention, along with the various features of novelty that characterize the invention, are pointed out with particularity in the claims annexed hereto and forming a part of this disclosure. For a better understanding of the invention, its operating advantages and the specific objects attained by its uses, reference should be had to the accompanying drawings and descriptive matter in which there are illustrated exemplary embodiments of the invention.

### BRIEF DESCRIPTION OF THE DRAWINGS

The present invention and its further advantages are explained in more detail in the following description on the basis of some not limitative embodiments, which are shown in the drawings. The drawings are schematically of nature and not to scale in which:
Fig. 1 shows the layer structure of a solar panel, according to an exemplary embodiment of the present invention;
Fig. 2 shows an inventive device of the present invention, according to an exemplary embodiment of the present invention;
Fig. 3 shows the inventive device of FIG 2 in more detail, according to an exemplary embodiment of the present invention;
Fig. 4 is an embodiment of the present invention wherein heat plate supported a processing chamber or a compression chamber of the inventive device introduced, according to an exemplary embodiment of the present invention;
Fig. 5 is a plan view illustrating a cover sheet of a solar panel as used in the apparatus of Fig. 2, according to an exemplary embodiment of the present invention; [0018] Fig. 6 shows a second variant of an inventive device, according to an exemplary embodiment of the present invention;
Fig. 7 is a standing arrangement of a base plate with a layer structure, wherein a compression of the glass plate with the layer structure by a lateral pressure occurred is illustrated, according to an exemplary embodiment of the present invention;
Fig. 8 is a horizontal arrangement of the base plate and the layer structure of FIG 7, wherein a compression of the glass plate with the layer structure by pressure from below from the direction of the layer structure is illustrated, according to an exemplary embodiment of the present invention;
Fig. 9 shows a further embodiment of the present invention in which a base plate also comes with a base plate having a layer structure pressed, according to an exemplary embodiment of the present invention;
Fig. 10 shows a variant of the present invention, wherein a photovoltaic layer coated carrier plate and another cover plate is arranged between the plates of a further layer to seal the photovoltaic layer and to connect the panels, according to an exemplary embodiment of the present invention;
Fig. 11 shows a variant of the present invention, wherein a base plate coated with a photovoltaic layer is pressed with a layer of foil existing building, according to an exemplary embodiment of the present invention;
Fig. 12 shows a further embodiment of the inventive device, according to an exemplary embodiment of the present invention;
Fig. 13 shows a further variant of the inventive device, wherein a suction device for a base plate of the solar panel is arranged in a lid of a vacuum chamber, according to an exemplary embodiment of the present invention;
Fig. 14 shows an inside of the lid of Fig. 13 in more detail, according to an exemplary embodiment of the present invention; [0027] Fig. 15 shows the variation of the present invention of Fig. 14 with an attached seal in a recess of the lid, wherein the space between the base and the lid has not evacuated or an evacuation has not yet completed, according to an exemplary embodiment of the present invention;
Fig. 16 shows the variation of the present invention from Fig. 15, in which the space between the lid and the base plate is evacuated, according to an exemplary embodiment of the present invention;
Fig. 17 shows the variation of the present invention of Fig. 15 with a closed but not evacuated, vacuum chamber, according to an exemplary embodiment of the present invention;
Fig.18 shows the variation of the present invention of Fig. 17 with a closed and evacuated vacuum chamber, according to an exemplary embodiment of the present invention;
Fig.19 shows a further variant of the present invention with closed but not yet evacuated vacuum chamber, according to an exemplary embodiment of the present invention;
Fig. 20 shows the variant of Fig. 19 with closed and evacuated vacuum chamber, according to an exemplary embodiment of the present invention;
Fig. 21 shows a closed but not evacuated, vacuum chamber of an inventive device (left part of Fig. 21) and the same device with a closed and evacuated vacuum chamber (right part of Fig. 21), according to an exemplary embodiment of the present invention;
Fig. 22 shows the inventive device of Fig. 17, according to an exemplary embodiment of the present invention; [0035] Fig. 23 shows the inventive device of Fig. 22 in a closed and evacuated condition, according to an exemplary embodiment of the present invention;
Fig. 24 shows a further variant of the inventive device, according to an exemplary embodiment of the present invention;
Fig. 25 shows yet another variation of the inventive device in which a covering between the covers of the vacuum chamber and the base plate is arranged, according to an exemplary embodiment of the present invention;
Fig. 26 shows a detail of the variant illustrated in Fig. 25 of the inventive device, according to an exemplary embodiment of the present invention;
Fig. 27 shows a further variant of the inventive device, according to an exemplary embodiment of the present invention;
FIG 28 shows a variant with a conveyor belt extending between the vacuum chamber and a layer structure, according to an exemplary embodiment of the present invention;
Fig. 29 shows a plan view of the conveyor belt according to a first variant of the inventive apparatus of Fig. 28, according to an exemplary embodiment of the present invention;
Fig. 30 shows a plan view of the conveyor belt according to a second variant of the inventive apparatus of Fig. 28, according to an exemplary embodiment of the present invention;
Fig. 31 shows a further variant of the inventive device with a base plate and a layer structure that is separated there from and extends above that ground plate, according to an exemplary embodiment of the present invention; [0044] Fig. 32 shows the variant of Fig. 31, wherein a part of the layer structure is in contact with the base plate and it shows a partially removed transportation sheet, according to an exemplary embodiment of the present invention; and
Fig. 33 shows the variant of Fig. 32, wherein the layer structure is fully in contact with the base plate and has been removed completely from the transport sheet.

It may be noted that in the various described embodiments, identical parts are given the same reference numbers or same component names. The disclosures contained in the entire description may be transferred mutatis mutandis to the same parts with the same reference numbers or same component names. Also, the selected position information, such as up, down, sideways, etc., may be based on the figure being described and illustrated, and are to be transferred accordingly to new orientation. Furthermore, individual features or feature combinations of the shown various embodiments may represent themselves independent, innovative, or inventive solutions.

### DETAILED DESCRIPTION OF THE INVENTION

The exemplary embodiments described herein detail for illustrative purposes are subject to many variations and structure and design. It should be emphasized, however that the present invention is not limited to a particular apparatus, device, system and methods for laminating sandwiched build up/bodies/structures or lay-ups or PV-modules, as shown and described. Rather, the principles of the present invention may be used with a variety of lamination configurations and structural arrangements. It is understood that various omissions, substitutions of equivalents are contemplated as circumstances may suggest or render expedient, but the present invention is intended to cover the application or implementation without departing from the scope of the it's claims.

In the following detail description, for purposes of explanation, numerous specific details are set forth in order to provide a thorough understanding of the present invention. It will be apparent, however, to one skilled in the art that the present invention may be practiced without these specific details.

As used herein, the terms 'a', 'an', 'at least' do not denote a limitation of quantity, but rather denote the presence of at least one of the referenced item, and the term 'a plurality' denotes the presence of more than one referenced items. The term 'photovoltaic layer' refers here a photoactive layer applied to a base, such as glass pate, a photovoltaic layer of interconnected photovoltaic cells, any other technology suited to be used on conjunction with the present invention, or any combination thereof. The term 'brought together' may be understood here as to mean that the preheated layer is brought in contact with at least one of the other layer under vacuum or in a protective gas atmosphere. Before producing the vacuum, the pre-heated layer is thus spatially spaced from the other layers. The term 'vacuum' refers the needed low pressure for preventing bubbles from forming. The term 'gas atmosphere' refers a predetermined gas or mixture thereof fulfilling certain properties such as being soluble in a material of the solar panel, not doing harm to solar cells or ribbons to prevent corrosion by gas entrapped in the module. The terms'recess' and 'holding means for a sealing' are used interchangeably. The seal may also be glued or melted on so that the holding means are just a part of e.g. a side wall.

According to an exemplary embodiment, the present invention provides an improved device and method for achieving increased efficiency and productivity for producing a solar panel built up of layers in a robust, cost effective, secure, environmental friendly manner.

According to an exemplary embodiment of the present invention, a pre-heated layer, for example a glass, ceramic plate or any other suitable material, may be pressed together with a layer structure, i.e. with a previously built and ready- arranged different layers of the solar panel, the problems connected with placing foils, such as EVA-foils on a hot glass plate, may be avoided. Therefore the present invention makes a layer structure possible in which not all layers of the solar panel have to be placed on top of each other before it is moved into the laminator. The layer structure of the other layers of the solar panel may be done separately from the pre-heated plate. Only under vacuum or in an atmosphere of the protective gas, the pre-heated layer is merged with the layer structure, i.e., brought into contact with it, and, may be pressed together with the layer structure. According to the present invention, the construction of the sandwich build up no longer has to be carried out outside the laminator, but it may be carried out inside the laminator. By merging and pressing under vacuum or a protective atmosphere, entrapment of gas in the solar panel may be prevented, that would otherwise lead to corrosion because of the 02 and H2O contained in air.

In an exemplary embodiment, the present invention allow the heating of a layer of the solar panel before its introduction into the laminator and thus reduce the residence time of the layer structure inside the laminator by the time needed for heating. Also the preheating of the layer may prevent dishing of the layer during further heat up. Because of the inventive solution, the utilization of the laminator may be improved significantly. It should also be stated that heating of the layer may also be done within the laminator before it is merged with the other layers.

According to another an exemplary embodiment of the present invention, the gas atmosphere may be of a gas that may be soluble in at least one of the encapsulant layers that envelope the photovoltaic layer and the pressing of the heated layer with the layer structure takes place in this atmosphere.

In an exemplary embodiment, the present invention allows even higher throughput or allow not using heat means inside the laminator. The material used for forming the pre-heated layer contains the material with the greatest heat capacity. In this way, the storage of heat in the preheated layer may be realized in an easy way. If enough energy is stored in the pre-heated layers, all energy needed for melting and or curing of the other materials thus forming the solar module may be subtracted from that layer.

In an exemplary embodiment of the present invention, a manufacturing process may be simplified if the pre-heated layer forms an outer layer of the solar panel. Here it has been found particular advantage that at least a pre-heated layer is formed by ceramics of glass.

In an exemplary embodiment of the present invention, the material of at least one of the pre-heated layers during pre -heating, is brought to a temperature greater than a melting temperature of at least one of the materials of the other layers or the temperature desired for lamination. This way the pre-heated layer may be transported to the laminator over relative long distances respectively at a relatively slow speed without additional heating means. In this context it is particularly advantageous when the pre-heated layer during pre-heating is pre-heated to at least 10%, preferably 15% or 20% of the phase transition temperature.

In a further exemplary embodiment of the present invention, the pre-heated layer may be heated by dipping it in a heat bath. Is the pre-heated layer, such as glass or ceramics, heated in a heating bath, this is preferably done before a washing. The composition of this fluid is advantageously selected so that the cleaning is supported or at least the liquid may be removed easily. The fluid may also support the lamination process.

In an exemplary embodiment of the present invention, the layer structure of the solar panel comprises at least a plastic layer or encapsulant, a cover sheet, at least a foil layer. The plastic layer or encapsulant may be transparent after lamination. The foil layer is adapted for the realization of the plastic layer being placed on the cover sheet as to form the layer structure or the lay-up. These terms are used intermittently. The active PV layer may be placed on the first foil layer and may be covered by a further layer for forming the encapsulant. In the laminator, the pre-heated layer is placed on this further layer inside the laminator and is presses there on in order to join the individual layers.

In an exemplary embodiment of the present invention, a very short residence time of the layer structure or lay-up in the laminator may be achieved in that the pre-heated layer, especially a glass or ceramic plate, may be brought to a temperature outside of the laminator needed for joining the layer. More particularly, the pre-heated layer may have that temperature when it is jointed to the other layers. Since transport of the pre-heated layer and the joining of the other layers reduce the temperature of the pre-heated layer, the preheated layer may be pre-heated to an even higher temperature.

In an exemplary embodiment of the present invention, a first layer of plastic foil encapsulates the solar layer, a second layer of plastic foil encapsulates the solar cell layer, and a cover layer may be unwound from rolls and fed into the laminator. The photovoltaic cells or more generally the active components may be placed directly between the layers inside the laminator. Alternatively, the solar cells may also be placed between the layers outside the laminator so that the solar cells may also be moved into the laminator.

In an exemplary embodiment of the present invention, to construct the layer structure, a first layer may be the cover layer, then an encapsulant may follow. The encapsulant maybe followed by the solar layer. Then a further layer of plastic foil that encapsulates the solar cells may follow. Thereupon the pre-heated layer may be placed. Since the pre-heated layer is pressed onto the previously formed layer structure in vacuum or in a protective gas atmosphere, the formation of bubbles may be prevented. Even if the joining of the layers is conducted in vacuum, gasses formed during curing still may form bubble inside the module. For example, an EVA foil placed on the pre-heated glass plate, may no longer be handled because it becomes too soft and the curing starts, making the foil stick to the glass plate. A particularly high production rate may thereby be achieved that the cover layer and the other foils are rolled up and thus stored outside of the laminator. The foils may be rolled of the rolls and passed through the laminator.

In an exemplary embodiment of the present invention, to avoid damage to the solar cells, solar cells may be placed inside the laminator on a first foil layer, used for the formation of the plastics layer or encapsulant. The solar cells may also be placed between the foil layers of the encapsulating layer of plastic in front of the laminator, thus further improving the production capacity of the laminator.

In the context of achieving a high production rate while achieving a simple structure, it is particularly advantageous when the cover sheet may be used as transportation sheet for components that may be placed on top thereof. For this purpose, for example, the transport sheet may have holes on opposite edges, which may engage with the feed direction rotating gears.

The production process may be further optimized by ejecting the solar modules after laminating in still hot from. The foils, used as cover sheet and or for the formation of the rest of the lay-up, may move out of the machine along with the module and may be cut afterwards.

In a further optimizing embodiment, before the foils are cut, the solar panel is transported on the cover sheet that serves as a transport sheet to a position where the solar panel is processed for a next step. [0066] In a further embodiment, individual foil layers of the layer structure are already in precut form and placed in the laminator. It may also be possible to cut these cutouts smaller than the pre-heated plate so that no materials protruding over the edges of the solar module after lamination have to be cut off.

In an exemplary embodiment of the present invention, the layer structure may have two glass or ceramic plates as outer layers and at least one first and at least one second encapsulating plastic layer to produce a solar cell, wherein between the first foil layer and the second foil layer solar cells are arranged. The pre-heated glass or ceramic plate may be applied to at least one plastic foil layer and is pressed together with the layer structure.

For thin film modules, the pre-heated layer may be the carrier which is capable of carrying at least any one of the active layer, the back sheet, a glass, a ceramic plate or any combination thereof.

According to another exemplary embodiment, the layer structure comprises at least a glass or a ceramic plate and a foil layer. The glass or ceramic plate may or may not be coated with a photovoltaic layer. The foil layer may be used for covering the photovoltaic layer. The foil layer in the finished solar module may forms a plastic layer that seals the photovoltaic layer or elements. In this case the glass or ceramics plate that is not coated or the glass or ceramics plate that is coated with a photovoltaic layer may be pre-heated. At least one foil layer may be brought in contact with the plate and the plate may be pressed against the layer structure.

According to another exemplary variant, the glass plate may be coated with a photovoltaic layer (PV coating). The layer structure containing a cover layer as well as at least a layer for covering the photovoltaic layer, that in the finished solar module forms a plastic layer, encapsulating the photovoltaic layer. The pre-heated layer being in contact with the at least one foil layer and being pressed against the layer structure.

The above-mentioned goal may also be achieved with a device of the type stated above that according to the present invention comprises a processing chamber. The processing chamber may comprises means for joining, i.e. for binging into contact, and processing together at least a pre-heat layer and at least one other layer.

According to another exemplary embodiment of the present invention, the working or processing chamber may be constructed as a pressure chamber, wherein mounting or holding means for the ground plate of the solar panel may be provided inside the pressure chamber. The mounting means enable the holding of the hot base plate at a certain distance from the side wall of the pressing chamber. The base pate and or side wall may be movable relative to each other. By means of these holding means, the hot ground plate, e.g. a glass or ceramic plate, may be held at a distance from the other materials in the press chamber, until the press chamber has been evacuated or has been filed with a gas atmosphere and a desired joining of the hot ground plate and the other layers. In this embodiment, no moving parts may be needed inside the processing chamber. Since the climate in this chamber may be rather harsh (vacuum, peroxides from the curing, heating), moving parts may have short live times. Also it is hard to get access to these parts (electrical cables, pressure conducts) without creating potential leakage of the processing chamber. This embodiment is also very suitable for placing solar cells onto other materials of the layup. Effective embodiments with moving parts in the processing chamber are however also conceivable.

The holding means may contain, for example, mountings for the base plate that may be moved towards the side wall. In this way a good support for the base plate may be provided and a secure and defined bringing in contact with the other materials in the pressure chamber may be assured.

According to an exemplary embodiment of the present invention, the vacuum chamber may be closed and evacuated or a gas atmosphere is created. The cover and base are moved toward each other to bring some materials in contact with each other.

A particularly advantageous exemplary embodiment of the inventive device provides that the holding means comprises a suction device for creating under-pressure between the base plate and an upper side wall, preferably the cover, of the pressure chamber, where the base plate abuts to. In this manner the ground plate may be fixed in a defined position before it is brought in contact with the other layers basically without mechanical holding means. Independent thereof safeguarding means may be provided in the press chamber that may catch the base plate if the catch plate frees itself from the suction means.

According to another advantageous exemplary embodiment of the present invention, recesses may be provided in the side walls, preferably the cover, of the press chamber. The mounting means or recesses may enclose one or more areas of different size and conducts may provide opening into these areas for evacuating air. This inventive embodiment may, if multiple mounting means are provided, have an advantage that base plates of different sizes and weights may easily be retained by the suction device while by mounting seals in the appropriate recesses or in multiple recesses at the same time. The size of the area to be evacuated may be determined easily and thus may be adopted to the size of the base plate.

Another exemplary embodiment of the inventive device provides that a cover of the compression chamber may be movable relative to a base. At least one resilient seal may be provided between the cover and the base. In this embodiment of the present invention there may be no more need for pressure membrane or a press inside the press chamber for realizing the required laminating pressure. More over the latter press may not have to be movable within the pressure chamber. The required laminating pressure on the layer structure will be achieved by the lowering of the lid.

A replacement of the seal, which may be formed as a wear part, may be facilitated by the fact that the seal is releasable mounted in a recess in the cover.

An automation of the production process is supported by the fact that the laminator that may be the device has a separate opening for introducing the pre -heated materials such as the pre-heated base plate.

The device may be evacuated or, alternatively has at least one inlet and at least one outlet for a gas, which may be the same outlet.

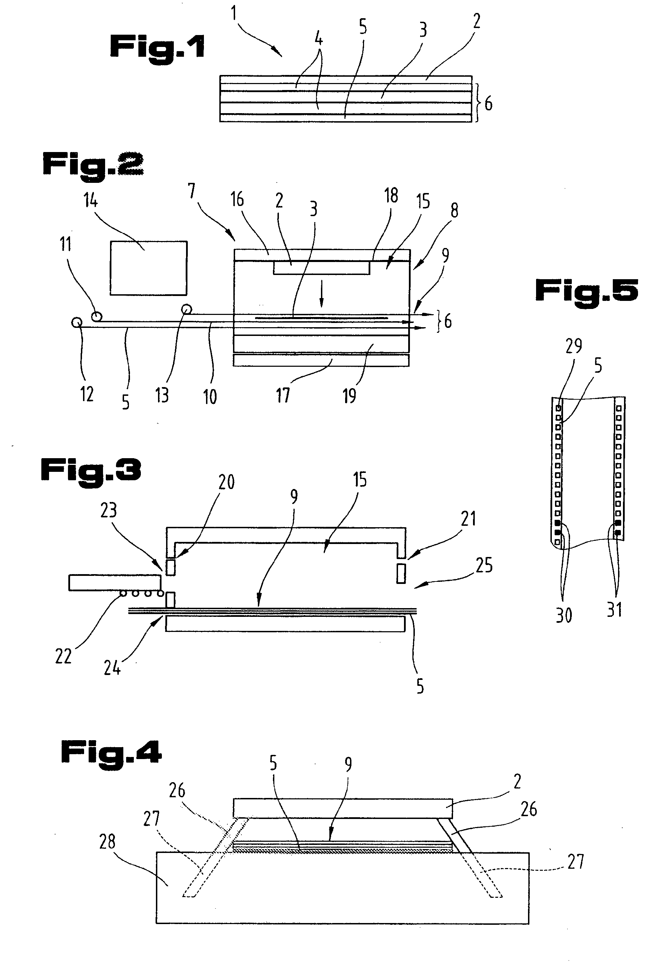

Fig. 1 shows a cross section through a solar panel 1, as it may be produced with the present invention. The solar panel 1 has a layer structure with a base plate 2, for example a glass plate, and a layer that is transparent after lamination and encapsulates the solar cells 3, an encapsulating plastic layer 4 and a cover sheet 5. The glass plate 2 serves as a carrier layer for the layer structure lying on top consisting of the further layers of the solar module 1. According to an exemplary embodiment of the present invention, the base 2 may be preheated separately from the layer structure 6 and may be pressed thereafter to the layer structure 6.

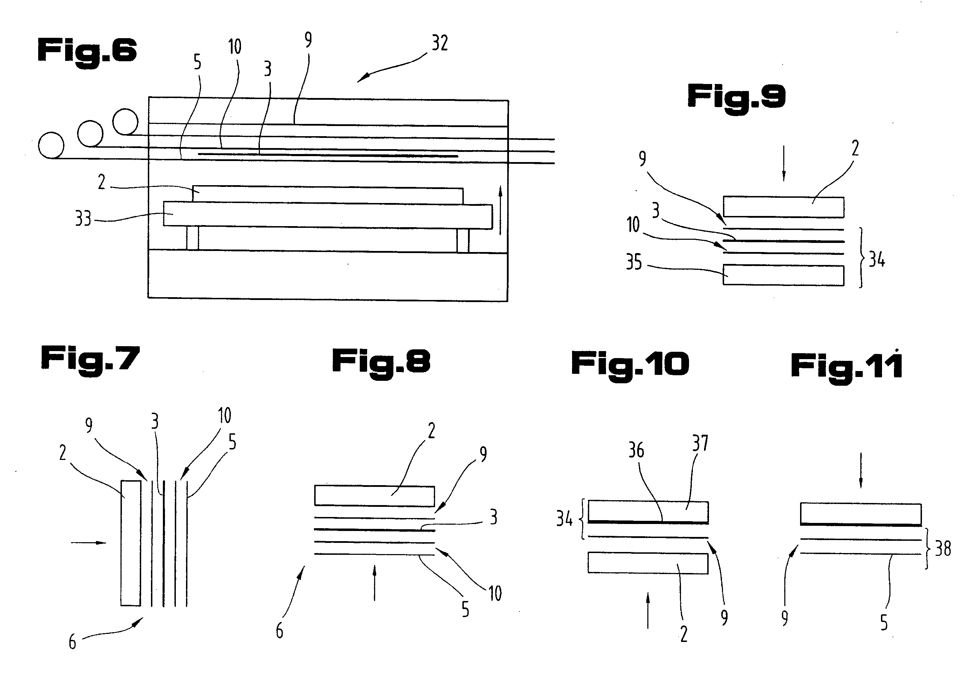

The present invention is not limited to the above solar panel, but all other types of solar panels or solar laminates may be produced with the inventive solution as well. For example, in the Figures 9-11 further examples of types of solar panels are shown, as may be produced with the inventive solution. Also, the present invention is not limited to only an outer layer, such as a glass or ceramic plate being pre -heated. Relevant to the present invention may be that one layer is pre-heated and joined to the other layers in vacuum or in a protective atmosphere. This way it may be possible, for example, to preheat several layers, where the temperature of these layers, as far as they touch before evacuation of the working chamber, remain below the melting temperature of the individual materials in order to avoid an unwanted entrapment of air. Also, the materials may not deform too much, e.g. under the influence of internal stresses or gravity.

According to Fig. 2 an inventive device 7 to produce solar panels, comprises a laminator 8 to connect the various layers of the solar panel 1. As Laminator 8 each device may be meant in which multiple layers of a solar cell may be joint, probably under influence of heat and pressure. The Laminator 8 may not necessarily to have a heating, as explained below in more detail. Sheets of cover foil 5, of a first foil layer 9 of the encapsulant 4, as well as a further sheet 10 may be fed through the laminator. The sheets 5, 9, 10 may be rolled of roles 11,12,13, the sheets 9,10 of the plastic foil 4 being arranged above the cover foil 5. The solar cells 3 may be placed between the foils inside or outside of the laminator 8.

Alternatively to the above embodiment with the sheets of foil, foils 9, 10 and 5 may be placed in the laminator 8 in a per-cut form. This may also be done manually or automatically. In this way, it may also be possible to insert a lay-up of pre-cut foils 5,9,10 and 5 as well as the solar cells 3 into the laminator 8 on a transporting system such as a conveyor belt.

Furthermore, the device may have heater 14 outside of the laminator for heating the base plate 2. The base plate 2 may be heated in a vacuum chamber 15 of the laminator 8. It should be noted that the terms 'vacuum chamber', 'pressing chamber' or 'processing chamber' in referred here are used interchangeably. It may be most important that the warming takes place symmetrically so that the base plate (eg glass or ceramic) may not dish or wrap. During the heating, the chamber may be evacuated. The material of the pre -heated layer may be heated in a plurality of ways, including but not limiting to: , example: using heating plate, as known from conventional laminators; using EM radiation: infrared heater, microwave, laser; by using an oven or baths, in which the material remains; using electric fields, known from high-frequency welding; using heat mats, e.g. electrical; inductive, electrical (Heating spiral); by means of combustion: for example by means of a glass flame. The above list may be not exhaustive and it may only be considered as an example.

If the preheat layer produced on site or treated (washed), the temperature the preheat layer gets due to this treatment may be used.

For example, if the base plate 2 may be heated in a bath with a hot liquid, this may be preferably done before a washing of the plate. The liquid of the bath may be chosen such that it supports the cleaning or at least may be removed easily from the base plate 2. It may be beneficial not to let cool down glass plates produced on site but use their high temperature. The bath itself may also be used for washing the plate 2.

The laminator 8 may, as known from the prior art, have a top or cover 16 and a lower part or bottom 17, wherein the laminator 8 may be opened by moving the upper part so that the working chamber 15, hereinafter also referred to as 'pressing chamber' or 'vacuum chamber', may be accessible. The base plate 2 may be held by holding means (not shown in Fig. 2) mounted to the pressing chamber closing cover. The base plate 2 may touch the side wall. A seal 45 may be adapted between the base plate 2 and the side wall. The base plate 2 may also touch a member thereof such as the seal 45. The holding means as described below in more detail may be designed, for example, as a suction device. The lower part of the laminator 8 as used herein may not have to be on the lower side of the laminator.

After evacuating the working chamber 15, the pressure required for the lamination may be generated by, for example, a press, after which the ground plate 2 may be lowered onto the layers. The press and or lower part 17 may have a pressing plate 18 on which a pressing cushion may be arranged. This press cushion may even out tolerances. However, this may also be done by an EVA layer. The press cushion may contain silicon and / or means for increasing the thermal conductivity, such as metal particles. By shaping the pressing cushion compressible, the thermal conductivity may be increased. The cushion may include metal springs or steel wool. An increase in the thermal conductivity of the pressing cushion may be particularly advantageous when below the pressing cushion 18, a heating plate may be provided or when the pressing cushion may be heated itself.

It is stated that the present invention is not limited to the above described construction of the laminator 8 or the device 7. For instance the laminator may contain multiple levels as may be known from stack laminators.

Furthermore, one robot may provide glass supply to two neighboring laminators.

Furthermore, the laminator 8 may have a heating plate 19 that may be arranged underneath the cover sheet to enable a further heating of layer structure inside the laminator 8 independent of the temperature of the pre-heated ground plate. When a heating plate 19 may be used, the cover layer 5 may be advantageously formed of a heat resistant material. Heat resistant here means that the cover layer 5 may be heat resistant at least up to the maximal temperature created by the heating plate.

It may be also possible to use one system for pre-heating of materials and curing of the solar modules after lamination. Typically, materials cure at a temperature that may be 5% lower, 10% lower or still lower than the processing temperature. A furnace may, for example, contain two chambers: one for the pre-heating and one for curing. The temperature of the first chamber may typically be higher than that of the second chamber.

At this place it may be noted that the arrangement of a heating plate 19 in the laminator 8 may not be necessary in all cases. Due to the large heat capacity, for example, of glass or ceramic materials, it may be possible to omit the heating, if such materials are used. In that case it may be suffice to insert the ground plate 2 at the desired temperature, for example, 150 degrees Celsius or higher, into the laminator 8 and press the base plate 2 by means of pressing means, for example a membrane or press, onto the foil layer 9.

During transport, the material of the pre-heated layer 2 may cool down. Also, when coming in contact with other materials, such as those of the layer structure or parts of the handling equipment, the temperature of layer 2 may drop. Therefore, the layer 2 may be pre-heated to a temperature higher than the minimal temperature that may be needed for the processing and so prevent the temperature from becoming too low. Lamination may be done by 180 <0>C, for example, glass may be heated without any problem to 200 to 250 degrees Celsius or even higher. In this way the other materials may be heated. Ideally the base plate 2 cools down during lamination (gives energy to the other materials) so that the curing may take place.

If enough energy is stored in the pre-heated layer 2, the forming of the solar panel 1 may be done without additional or with just with little heating, which makes the process faster. The pressing plate 16 of the press or the heating plate may contain an isolation layer so the flow of energy from the pre-heated layer 2 to those parts is reduced as much as possible.

It may be noted that the pre-heated layer 2 may be heated additionally or may be kept on a desired temperature when it may be inserted into the laminator 8. In order to store as much energy as possible in the pre-heated layer 2, without changing its aggregation state, the pre-heated layer 2 may be heated up to 50%, 70% or 90% of its phase change temperature of the material the pre-heated layer 2 is made of. A range of the phase change temperatures of some used materials of the lay-up may be, for example:
Glass - ca. 1000 °C - 1600 °C
EVA - ca. 150 °C
PVB - ca. 90-120 °C

The pressing of the hot layer 2 onto the layer structure 6 may be done in vacuum, in order to prevent corrosion of the solar cells and there connectors due to components in the air such as H2O and 02. The vacuum may remove these components from the lay up so that they are not trapped inside the module. Also the formation of air bubbles may be counteracted by removing as much as possible from the vacuum chamber.

According to another embodiment of the present invention the processing chamber of laminator 8 may not be evacuated, or not only evacuated, but may be filled with a protective gas, so that lamination process may be completed in an atmosphere of protective gas. For foils 9 and 10, for example EVA, CO2 may be used as protective gas. Other foils or materials and gasses may be suitable as well, as long as the gas is soluble in the other materials used. The protective gas may be soluble in at least one of the used foils, such as PVB and CO2 and TPU (thermoplastic polyurethane) and CO2. In order to facilitate the flowing of the gas into and out of the chamber of the laminator 8, the chamber may be provided with at least one controllable inlet and/or outlet, as indicated in Fig. 3 with numerals 20 and 21.

As shown in Fig 3, means may be provided for automatically inserting the layer 2 into laminator 8 instead of manually inserting the pre -heated layer 2 into the laminator 8. In order to do so, the pre -heated layer 2 may be moved into the laminator 8 by means of any transportation system such as a robot or a conveyor belt. The laminator 8 may be provided with an opening 23 for inserting the hot layer 2. Preferably, the opening 23 may be located above an opening 24 for introducing other materials of the lay up 5, 9, 10. These materials may be possibly attached to a sheet that may be rolled up on rolls 11, 12, 13. Both the opening 23 and opening 24 may be sealable, probably with an elastic or metal cover. This way, after insertion of the materials 2, 5, 9, 10, the processing chamber 15 of the laminator 8 may be closed and evacuated or swamped with the protective gas. If needed, an opening 24 may also be provided with closing means that may be in contact with the sheets 5 and 9.

In order to be able to lower layer 2 onto the foil layer 9, the laminator 8, as shown in Fig. 4, may be provided with protrusions or supports 26 for layer 2 that may be movable in the direction of plane of the cover layer 5. These protrusions may be pins that are movably mounted in the holes 27 of a base plate 28, which may be a heating plate. Before the layer 2 is inserted thru opening 23 into the laminator 8, the pins may be moved as to protrude from the hole so that the layer 2 lays on the pins. Now the processing chamber 15 of the laminator 8 may be evacuated and the pins may be moved into the holes 27. After evacuation of the processing chamber 15, the materials may be pressed together. If the pins extend in a direction slanted to the transportation direction of the layer 2 and sheets 9, 10, 5, the pins may be moved as to completely disappear in the holes 27 without touching the materials. In this way the layer 2 may be lowered onto the other materials. The pins may be moved by means of hydraulics, pneumatics, a motor or any other suitable means, not shown in Fig. 4. It may be also conceivable that the pins may be forced upwards by springs that are depressed by the layer 2 when this is pressed by the pressing means, such as a membrane or press. It may be also possible to let the pins move in a direction perpendicular to the ground plate. This may require adaptation of the materials of the module though. The layer 2 maybe made a little bit bigger than the materials of the layup or they may extend thru opening in these materials. As an alternative, the pins 26 for holding layer 2 maybe replaced by a frame that may move into an appropriate opening in the base plate 28.

In a further embodiment, the layer 2 may be mounted to the cover or ceiling 16 of the processing chamber 8, for example by suction means or by temporarily creating an under pressure between the layer 2 and the cover 16. The layer may be moved towards the other materials of the lay up. In order to do so the suction means may be movable relative to the cover 16 or the cover as a whole may be lowered. In the latter case, the movement of the cover 16 may also be used to press the layer 2 onto the other materials.

According to Fig. 5 the transportation of the foil layers 5, 9, 10 as well as the hot solar panel 1 out of the laminator 8, may be facilitated by means for transportation such as by holes 29 near the edges of the cover layer 5 or any other suitable layer, in which gears 30, 31 may grip as to move the foil layer 5, 9, 10 as well as the module. Here the cover layer 5 may serves as transport sheet.

After the lamination process has completed, the probably still hot solar panel 1 may be removed from the laminator 8 to undergo additional treatment, such as partially removal of parts of the foils 9, 10, 5 that protrude beyond the border of the module 1. This may be done manually or automatically, for example by means of (rotating) knives or cutters. In a cost effective manner, the module may be transported by means of the transport foil to a site where the next processing may be conducted.

As shown in Fig. 6, the pre-heated sheet 2 in the laminator 32 may also be pressed on to the materials of the layer structure or foil layer 9 from below. The order of the foil layers has to be adapted accordingly: here the foil layer 9 comes on top and form the back sheet, below that come the encapsulant 10, the solar cells 3 and another encapsulant 5. The solar cells have the sunny-side down. In the shown embodiment, the layer 2 may be pressed from below against the materials of the layer structure 6 by a press 33.

According to Fig. 7, the layer 2 and the layer structure 6 may also be oriented in a standing or slanted manner. The pressure now may be applied from the side of the layer 2 or the layer structure 6.

Fig. 8 shows another embodiment of the present invention, in which the placement of the pre-heated layer 2 and the layer structure 6 agree with Figs. 2 and 3. Differently from Fig. 2 the pressure may be not applied from the side of the layer 2 but from the side of the layer structure 6.

According to figure 9, the layer structure 34 may comprise a glass or ceramic plate 35, as well as a first and a second encapsulation layer 9, 10 that may form an encapsulation 4 around the solar cells 3. Between the first foil layer 9 and the second foil layer 9, as may be the case in the embodiment of Fig. 2, solar cells 3 may be present. The layer 2 that may be heated out side of the laminator 8 may be placed against the foil layer 9 and pressed against the layer structure 34. The layer structure 34 may include a second glass or ceramic layer that may be pre-heated or not. Here the pressure may be applied from the side of the pre-heated layer 2 or layer structure 34, or both.

It may be noted that in the above embodiment next to the mentioned foils layer and layers, an additional intermediate layer may be provided, for example a web that lies on the passive side (not the sunny side) of the solar cells.

As shown in Fig. 10, the layer structure 34 may contain a photovoltaic layer 36 applied to the glass plate 37 as well as a foil layer 9 for covering layer 36. The foil layer 6may be e.g. an EVA or silicon layer that in the final module may build an encapsulation for the PV layer 36. Alternatively, the layer structure 38 may be formed instead of the PV coated glass plate 37 by a glass plate 37 that may not have active layer 39 (not shown) and a foil 9. The glass plate 37 may be pre-heated in both cases.

Depending on the requirement, the layer structure 38 may comprises the glass plate 39 or the PV coated glass plate 37. The glass plate 39 or the glass plate 37 with the photovoltaic layer 36, may be pre-heated outside of the laminator and may be applied to the foil layer 9 and pressed against the layer structure 38.

However, in principle it may be also possible to pre-heat both glass plates 37, 39 outside of the laminator and join them simultaneously to layer 9 and press them together. This option may be most interesting in the standing position of the glass plate 37, 39 in the laminator and the foil 9 may be mounted between them. The term 'layer structure' here means a multitude of layers inside or outside of the laminator that enable the pressing together of these layers to form a module or part thereof. Meaning, the layers of the layer structure 6, 34, 38 may be placed beside or above each other so that they may be pressed and joined together, provided the right temperatures. The layers of the layer structure 6, 34, 38 do not necessarily have to touch each other before the pressing. This may be particularly true for the standing or hanging orientation of the individual layers.

According to Fig. 11 the layer structure 38 may contain the cover layer 5 as well as the foil layer 9 for covering of the photovoltaic layer 36 of the glass plate 37. The preheated glass plate 37 may be brought in contact with the foil layer 9 and pressed against the layer structure 38. The pressure may be applied in the direction of the glass plate 37 and or in the direction of the layer structure 38.

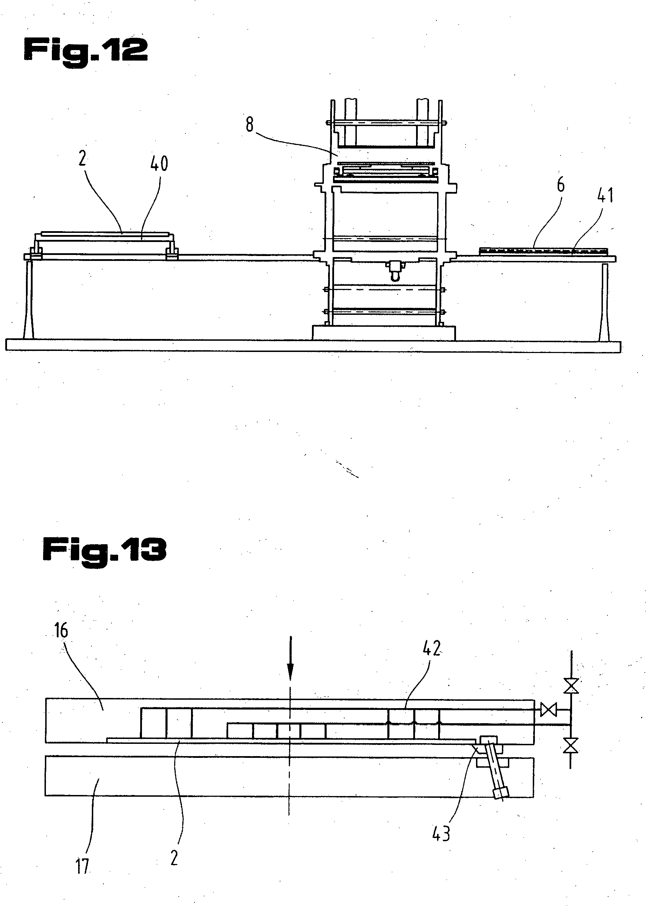

As shown in Fig. 12, the materials may be transported by different transportation means into the laminator 8.

The heated layer 2 or base plate may be moved into the laminator 8 on a carriage 40 (left) moved. According to this example, there it may be lifted from the carriage 40 by means of a suction cup with almost the same size as the plate itself. After the carriage 40 has been removed from the laminator 8, a conveyor belt 41 transports the layer structure 6 consisting of the other layers into the right position. The suction cup may now in downward direction and thus closes the vacuum chamber.

Also hot parts (glass, ceramics or the produced module) may be processed on one side of the laminator while other materials (layer structure) may be handled on the other side. Thus dangerous areas are better protected. Since the laminated module has to be kept warm for a certain period of time so that the curing or cross linking in the module may continue, the module may be led back into the oven where the base plate has been preheated.

According to Fig. 13, the pre-heated base plate 2 may be held or lifted by means of a vacuum (suction cup and channels 42) or by means of slide 43. In the example shown, slide 43 may be automatically pushed aside when the covers 16 moves down.

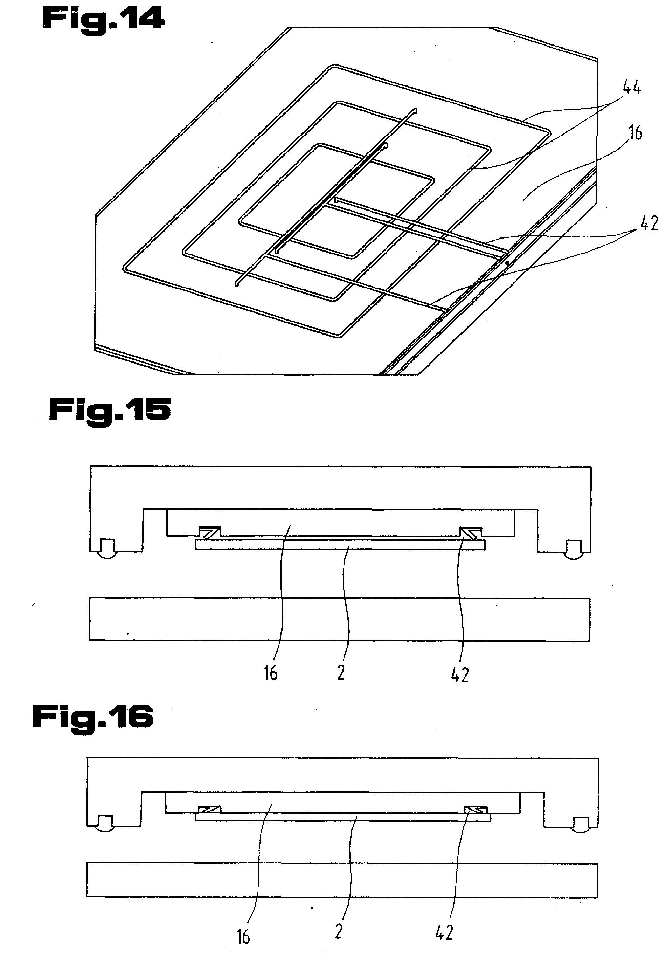

As shown in FIG 14, means for holding the seal 44 may be formed as recesses in the cover 16, so that base plates 2 of different sizes may be held by producing underpressure between a base plate 2 and the cover 16. A seal may be placed in the recesses 44 that corresponds best to the size of the glass plate 2, for example a rubber seal may be inserted. The plate 2 and this seal form a suction cup that may be evacuated through the channels 42 in order to hold the plate 2. Multiple recesses may be provided that enclose areas of different sizes.

The seal placed in recess 42 advantageously compresses a lip, as shown in Fig. 15 and 16. If the base plate 2 may held against the lips and air may removed (Fig. 15), the base plate 2 may be pressed against the cover 16 (Fig. 16).

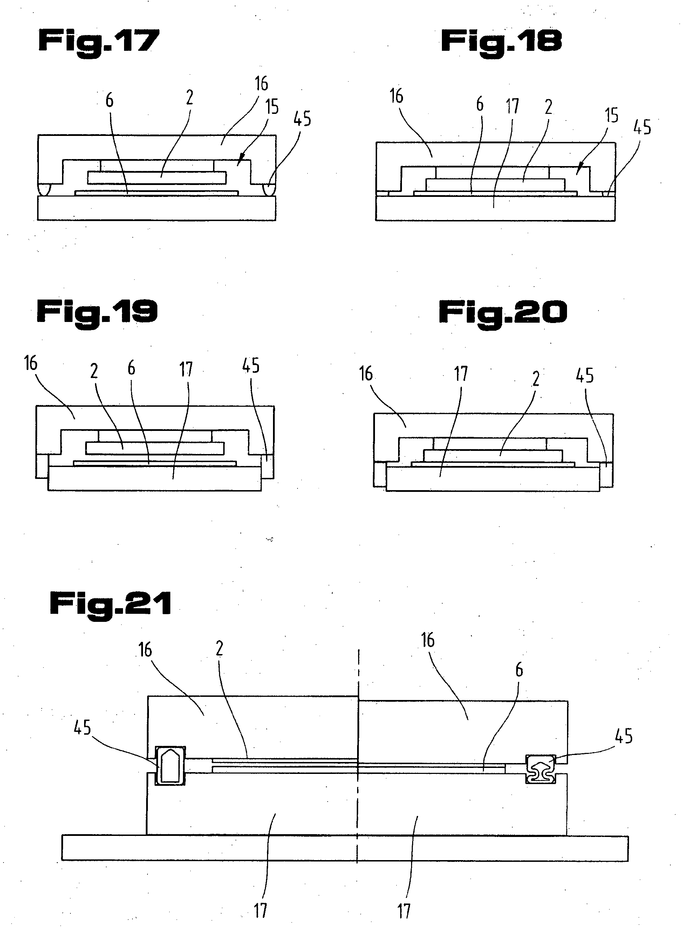

According to Fig. 17 and 18, the base plate 2 may be advantageously rigidly held by the cover 16. Here the vacuum chamber 15 closes when the cover 16 may move in the direction of the lower part 17. The vacuum may be created when the chamber 15 may be closed. Until the vacuum has been established, to the base plate 2 may not be in contact with the other layers 6, otherwise air may be trapped. If the desired vacuum has been reached, cover 16 may be lowered further into a second relative position and the base plate 2 and the other layers 6 may come into contact. The invention is not limited to these positions of the base plate 2 and the layers 6 or these materials.

It is an advantage of the present invention, that a seal 45 may be provided between the cover 16 and the lower part 17, which closes the vacuum chamber 15 during the evacuation, but as the cover 16 moves down may deform elastically without taking damage, even if this process may be repeated many times at high temperatures. The seal 45 may, for example, consist of a plastic or metal. In the first case, it may be designed to be inflatable. The pressure in the seal 45 may in that case for example when moving down the cover 16 may be kept constant. This ensures that a good seal may be present, with stressing the material of the seal too much. This type of sealing may be advantageous in embodiments where no pre-heating may be conducted as well.

Also systems may be conceivable, in which the shape of the seal 45 does not change greatly when moving down the cover, as shown for example in the Figs. 19 and 20.

It may be advantageous if the seal 45 as in Fig. 19, 20 and 21 may be mounted to the cover 16 so that it may not get dirty and the base plate 28 and the lower part 17 may be cleaned more easily. Ideally, the lower part 17 may be flat. In Fig. 21, the seal 45 may be formed as a tube and attached to the cover 16. The left part of Fig 21 shows the device with a not yet lowered cover 16, while in the right part of Fig. 21, the device is shown with a lowered cover 16 and a compressed seal 45.

Since the seal 45 may be a wear part, this should be easy to replace. The seal 45 should be releasable attached to the cover 16, for instance by means of a snap connection.

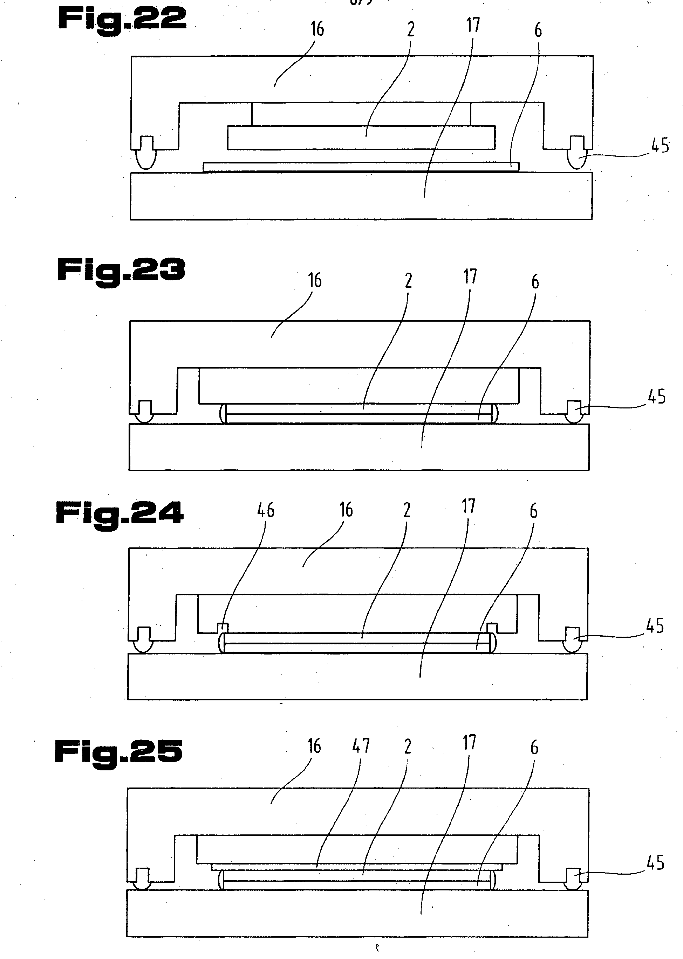

If the seal 45, as shown in Fig. 22, may be designed to be inflatable, also the connection to the air pressure system must be easy to release.

As shown in Fig. 23, during lamination, the layers of plastic melt and may leak out on the side of the laminate and pollute the cover 16 or lower part 17. This happens because from the materials in the layer structure 6 gases escape, foaming the liquefied materials.

The simplest measure to prevent the foaming may be to lift the vacuum before this happens. This may but does not have to lead to formation of bubbles because the gases remain in the laminate.

The contamination of the lid 16 and lower part 17 may be counteracted by the cover 16, as shown in Fig. 24, having recesses 46.

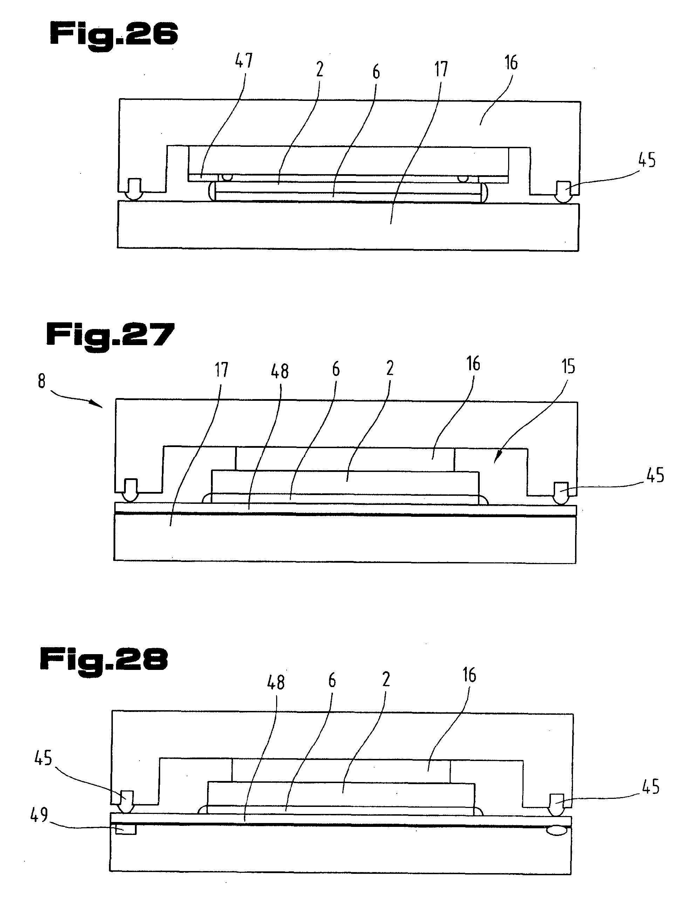

Furthermore, as shown in Figs. 25 and 26, a release or cover sheet 47 may be provided on the cover 16. This cover sheet 47 may be disposed at least partially between the base plate 2 and the cover lid 16.

The cover sheet 47 extends, as shown in FIG 26, however, advantageously not in the interior of the suction cup, but only on the edges of the base plate 2, where the pollution may be expected. The cover sheet 47 may be attached to the lid 16 and be easily replaceable. Also, the seal of the suction cup and the cover sheet 47 may form one part, which may be moved along with panel from the press chamber after lamination.

Furthermore, it may be advantageous if the non-heated sheet materials may be introduced into the laminator 8 on a conveyor belt 48 or transport sheet as known from conventional laminators

As shown in Fig. 27, the layer structure 6 may be introduced into the vacuum chamber on the conveyor belt 48. It may be difficult to avoid that the layer structure 6 adheres to the conveyor belt 48 during lamination.

In order to more easily remove the modules after lamination from the conveyor belt 48, a release or cover sheet may be provided that does not adhere to the layer structure 6 as much as the conveyor belt 48 and or may be cleaned more easily or may be moved along with the module, such as a part that may be only used for one module or that may be removed from the module in a later stage, maybe when the materials have hardened, or that remains part of the module.

In order to be able to better seal the vacuum chamber 15 when using a conveyor belt, a sealing soft element 49 or a recess in the base plate 28 (not shown) may be provided opposite the seal 45 near the lower part 17 of the laminator 8, as is shown in Fig. 28. This counter element 49 of the sealing 45 may be positioned below the conveyor belt 48, so that the conveyor belt 48 runs between the seal 45 and its counter element 49. The additional counter element 49 that may also be formed in the same manner as the seal 45, a better sealing of the vacuum chamber 15 may be achieved, especially when a conveyor belt 48 may be used. The counter element 49 may protrude (right) from base plate 17 or may be flush (links) with its surface.

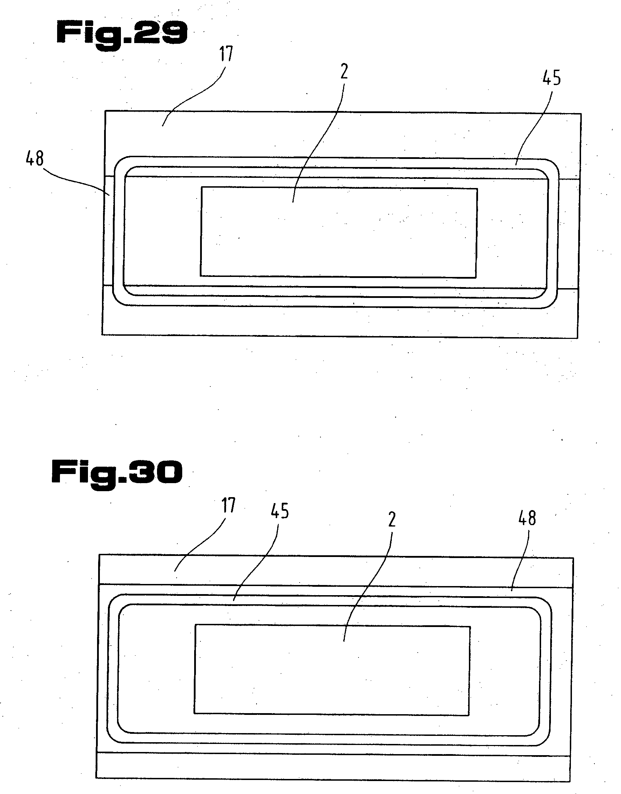

If the layer structure 6 may be transported into the vacuum chamber 15 by means of a conveyor belt, the latter may depending on its design and width overlap the seal 45,49 on two (Fig. 29) or four (Fig. 30) sides.

Furthermore, the conveyor belt 48 may include at least one depression, into which the materials of the layer structure 6 fit. Thus, the position of these materials or layers may be defined exactly. This allows e.g. to avoid or reduce the amount of materials protruding from the module. Also, markers may show where the materials have to be placed on the conveyor belt 48. The depression may support the sealing of the vacuum chamber.

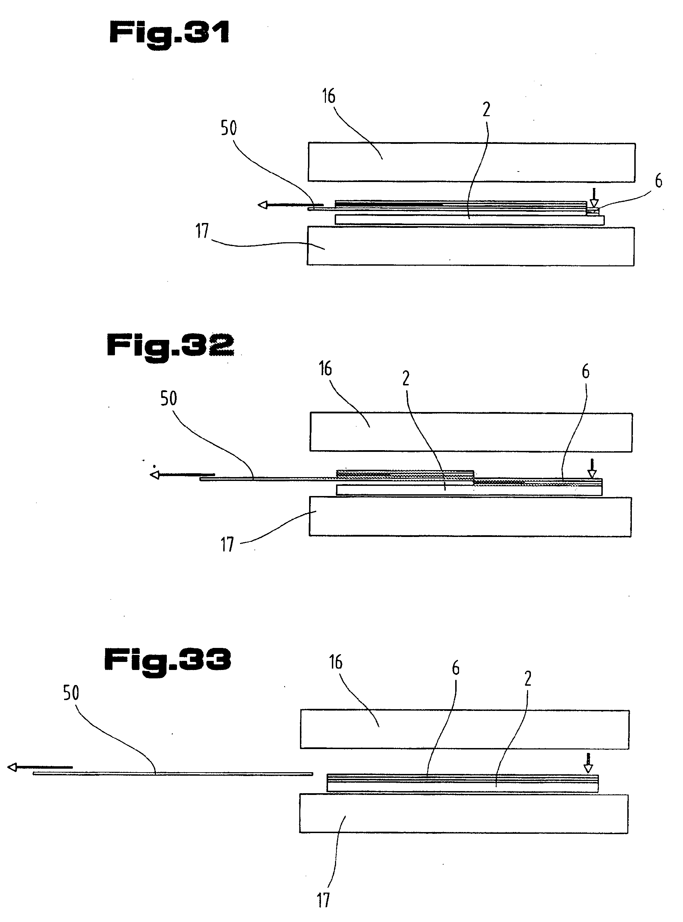

As shown in the Figs 31-33, the pre-heated base plate 2 may also be placed below the layer structure 6. The other, in general flexible layers may then be positioned on a conveyor belt 50 above the base plate 2 (Fig. 31).

The conveyor belt 50 has subsequently to be removed, without the layer structure 6 shifting relative to the base plate 2. This may for example be achieved by pulling the conveyor belt 50 to the side (left in Fig. 32), while the layer structure of 6, e.g. by means of a clamp may be held or in some place may be pressed on the base plate 2. In both cases enough friction may be generated to prevent the layer structure 6 from moving along with the conveyor belt 50. In the latter case, a recess may be provided in the conveyor belt 50 in order to allow pressing the layer structure 6 onto the base plate 2, while the conveyor belt 50 may be removed. All this may be done under vacuum or gas atmosphere to prevent the inclusion of air in the module. In order to save space, the transportation means 50 may be rolled up.

The embodiments shown in Figs. 31-33, may be particularly suitable for the manufacturing of glass - glass modules, moreover, modules that have a glass plate as first and last layer. In this case, a second glass plate may be held by the cover, e.g. as shown in the Figs. 15 to 20.

In conclusion, it may be said that by the inventive solution, the residence time of the sandwich build up in the laminator as well as the cycle time may be reduced significantly. [00141] The given embodiments are possible variants of the inventive solution, the present invention not being limited to the shown embodiments. In particular, combinations of the different embodiments are possible as well, as far as these variations lay in the normal abilities of a person skilled in the art. Also all variations are included that implement the solution according to the present invention and are not described explicitly or have not been shown or follow from any combination thereof as far as they lay within the protective scope. Also the protection is extended to the individual components of the inventive device, as far as they are essential for the realization of the present invention.

**Reference characters list**

| | | | |
|---|---|---|---|
| 1. | Solar panel | 26. | Outriggers/ supports/pins/ |
| 2. | Pre-heated layer/base plate | | protrusions |
| | (also 3, 4, 5, 6, 34, 38) | 27. | Holes |
| 3. | Solar cells | 28. | Base plate |
| 4. | Plastic layer | 29. | Holes |
| 5. | Cover layer | | 30. Gear |
| 6. | Layer structure | 31. | Gear |
| 7. | Device | 32. | Laminator |
| 8. | Laminator | 33. | Press resources |
| 9. | Foil | 34. | Layer structure |
| 10. | Foil | 35. | Glass plate |
| 11. | Role | 36. | Photovoltaic layer (PV layer) |
| 12. | Role | 37. | Coated glass plate |
| 13. | Role | 38. | Layer structure |
| 14. | Heating | 39. | Uncoated glass |
| 15. | Working chamber | 40. | Sledge |
| 16. | Cover | 41. | Conveyor belt |
| 17. | Lower part | 42. | Channels |
| 18. | Pressing plate | 43. | Pusher |
| 19. | Heating plate | 44. | Recesses |
| 20. | 20. Inflow | 45. | Seal |
| 21. | 21. Outflow | 46. | Recess |
| 22. | Roll | 47. | Covering sheet |
| 23. | Opening | 48. | Conveyor belt |
| 24. | Inlet | 49. | Sealing element |
| 25. | Outlet | 50. | Conveyor belt |

## Claims

1. A method for producing a solar panel built up of a plurality of layers, wherein one layer is pre-heated and put together under vacuum or gas atmosphere with at least one other layer,
wherein the pre-heated layer has a large heat capacity as compared to at least one of the other layers,
wherein the pre-heated layer forms an outer layer of the solar panel,
wherein the pre-heated layer is formed of ceramic or glass.

2. The method according to claim 1, wherein the gas is soluble in at least one layer.

3. The method according to claims 1-2, wherein a material of at least one pre-heated layer under the preheating is brought to a temperature, wherein the temperature is greater than the melting temperature of at least one of the materials of the other layers and/ or the temperature is equal to a temperature that makes materials of the other layers deform.

4. The method according to claims 1-3, wherein a preheating is done by dipping the preheated layer in a heat bath.

5. The method according to claims 1-4, wherein the pre-heated layer under the preheating is heated to at least 10%, at least 15% or at least 20% of their phase transition temperature.

6. A device to produce a solar panel built up of layers by a method according to claims 1-5, wherein the device comprising: a working chamber (15) which is capable of being evacuated and / or filled with a gas or combination thereof, wherein the working chamber (15) having means for combining the pre-heated layer with at least one other layer, wherein the working chamber (15) is built as a compression chamber for retaining at least a layer structure of a solar module consisting of multiple layers, wherein means for holding a base plate of the solar module are provided in the compression chamber, wherein at least any one of the base plate (28), a side wall of the compression chamber or any combination thereof being movable relative to each other,
wherein said base plate is said preheated layer made from glass or ceramics,
wherein the means for holding said base plate comprises at least a movable support, the movable support is capable of moving in a direction of the side wall,
wherein the means for holding the base plate comprises at least a suction device for generating under pressure between the base plate and a side wall, wherein the side wall is a cover of the working chamber on which the base plate touches,
wherein in the side wall of the working chamber (15) at least a holding means are provided for a seal (45), wherein the holding means provided in at least any one of the side wall of the working chamber, and at least a channel is provided for the extraction of gas from the working chamber,
wherein the first side wall and the second side wall of the working chamber are capable of moving relative to each other, wherein the seal (45) is provided between the first side wall and the second side wall, wherein in a first relative position the working chamber (15) is closed and evacuated or a gas atmosphere is established therein, wherein as the first side wall and the second side wall move to a second relative position materials inside the working chamber are brought in contact with each other.

7. The device according to claim 6, wherein inside the working-chamber means are provided for catching the base plate when the base plate frees itself from the means for holding it,

8. The device according to claim 6, wherein the seal (45) is attached interchangeably with holding means.

## Patentansprüche

1. Verfahren zum Herstellen eines Solarpanels, das aus mehreren Schichten aufgebaut ist, wobei eine Schicht vorgewärmt und unter Vakuum oder Gasatmosphäre mit mindestens einer weiteren Schicht zusammengesetzt wird,
wobei die vorgewärmte Schicht im Vergleich zu mindestens einer von den anderen Schichten eine große Wärmekapazität aufweist,
wobei die vorgewärmte Schicht eine äußere Schicht des Solarpanels bildet,
wobei die vorgewärmte Schicht aus Keramik oder Glas gebildet ist.

2. Verfahren nach Anspruch 1, wobei das Gas in mindestens einer Schicht löslich ist.

3. Verfahren nach den Ansprüchen 1 bis 2, wobei ein Material von mindestens einer vorgewärmten Schicht bei Vorwärmung auf eine Temperatur gebracht wird, bei der die Temperatur größer als die Schmelztemperatur von mindestens einem der Materialien der anderen Schichten ist und/oder die Temperatur gleich einer Temperatur ist, die bewirkt, dass die Materialien der anderen Schichten deformiert werden.

4. Verfahren nach den Ansprüchen 1 bis 3, wobei eine Vorwärmung durch Eintauchen der vorgewärmten Schicht in ein Wärmebad erfolgt.

5. Verfahren nach den Ansprüchen 1 bis 4, wobei die vorgewärmte Schicht bei der Vorwärmung auf mindestens 10 %, mindestens 15 % oder mindestens 20 % ihrer Phasenübergangstemperatur erwärmt wird.

6. Vorrichtung zum Herstellen eines aus Schichten aufgebauten Solarpanels durch ein Verfahren nach den Ansprüchen 1 bis 5,
wobei die Vorrichtung umfasst: eine Arbeitskammer (15), die von einem Gas evakuiert und/oder damit gefüllt werden kann oder eine Kombination davon, wobei die Arbeitskammer (15) ein Mittel zum Kombinieren der vorgewärmten Schicht mit mindestens einer weiteren Schicht aufweist,
wobei die Arbeitskammer (15) als eine Druckkammer gebildet ist, um mindestens eine Schichtstruktur eines Solarmoduls zurückzuhalten, das aus mehreren Schichten besteht, wobei ein Mittel zum Halten einer Grundplatte des Solarmoduls in der Druckkammer vorgesehen ist, und wobei mindestens eines von der Grundplatte (28), einer Seitenwand der Druckkammer oder irgendeiner Kombination davon relativ zueinander beweglich ist, wobei die Grundplatte die vorgewärmte Schicht ist, die aus Glas oder Keramik hergestellt ist,
wobei das Mittel zum Halten der Grundplatte mindestens einen beweglichen Träger umfasst und der bewegliche Träger sich in einer Richtung der Seitenwand bewegen kann,
wobei das Mittel zum Halten der Grundplatte mindestens eine Saugvorrichtung umfasst, um zwischen der Grundplatte und einer Seitenwand Unterdruck zu erzeugen, wobei die Seitenwand eine Abdeckung der Arbeitskammer ist, mit der die Grundplatte Berührung hat,
wobei in der Seitenwand der Arbeitskammer (15) mindestens ein Haltemittel für eine Dichtung (45) vorgesehen ist,
wobei das Haltemittel, das in mindestens einem von der Seitenwand der Arbeitskammer und mindestens einem Kanal vorgesehen ist, zum Extrahieren von Gas aus der Arbeitskammer vorgesehen ist,
wobei sich die erste Seitenwand und die zweite Seitenwand der Arbeitskammer relativ zueinander bewegen können, wobei die Dichtung (45) zwischen der ersten Seitenwand und der zweiten Seitenwand vorgesehen ist, wobei die Arbeitskammer (15) in einer ersten relativen Position geschlossen und evakuiert ist oder eine Gasatmosphäre darin hergestellt ist, wobei Materialien innerhalb der Arbeitskammer in Kontakt miteinander gebracht werden, während sich die erste Seitenwand und die zweite Seitenwand zu einer zweiten relativen Position bewegen.

7. Vorrichtung nach Anspruch 6, wobei innerhalb der Arbeitskammer ein Mittel vorgesehen ist, um die Grundplatte zu fangen, wenn sich die Grundplatte von dem Mittel befreit, das sie hält.

8. Vorrichtung nach Anspruch 6, wobei die Dichtung (45) austauschbar mit einem Haltemittel befestigt ist.

## Revendications

1. Procédé de production d'un panneau solaire constitué d'une pluralité de couches, dans lequel une couche est préchauffée et assemblée sous vide ou atmosphère gazeuse avec au moins une autre couche, dans lequel la couche préchauffée a une grande capacité thermique comparée à au moins une des autres couches, dans lequel la couche préchauffée forme une couche extérieure du panneau solaire, dans lequel la couche préchauffée est formée de céramique ou de verre.

2. Procédé selon la revendication 1, dans lequel le gaz est soluble dans au moins une couche.

3. Procédé selon une des revendications 1-2, dans lequel un matériau d'au moins une couche préchauffée sous le préchauffage est amenée à une température, dans lequel la température est supérieure à la température de fusion d'au moins un des matériaux des autres couches et/ou la température est égale à une température qui rend déformables les matériaux des autres couches.

4. Procédé selon les revendications 1-3, dans lequel un préchauffage est effectué en trempant la couche préchauffée dans un bain thermique.

5. Procédé selon les revendications 1-4, dans lequel la couche préchauffée sous le réchauffage est chauffée à au moins 10%, au moins 15% ou au moins 20% de leur température de transition de phase.

6. Dispositif pour produire un panneau solaire constitué de couches par un procédé selon les revendications 1-5, dans lequel le dispositif comprend : une chambre de travail (15) qui est capable d'être évacuée et/ou remplie d'un gaz ou d'une combinaison de ceux-ci, dans lequel la chambre de travail (15) comporte un moyen pour combiner la couche préchauffée avec au moins une autre couche,
dans lequel la chambre de travail (15) est construite comme une chambre de compression pour retenir au moins une structure de couche d'un module solaire constitué de multiples couches, dans lequel des moyens pour retenir une plaque de base d'un module solaire sont prévus dans la chambre de compression, dans lequel au moins un quelconque de la plaque de base (28), une paroi latérale de la chambre de compression ou n'importe quelle combinaison de celles-ci sont déplaçables l'une par rapport à l'autre,
dans lequel ladite plaque de base est ladite couche préchauffée constituée de verre ou céramique, dans lequel le moyen de retenue de ladite plaque de base comprend au moins un support mobile, le support mobile est capable de se déplacer dans une direction de la paroi latérale,
dans lequel le moyen de retenue de la plaque de base comprend au moins un dispositif d'aspiration pour générer une dépression entre la plaque de base et une paroi latérale, dans lequel la paroi latérale est un couvercle de la chambre de travail que la plaque de base contacte,
dans lequel dans la paroi latérale de la chambre de travail (15) au moins un moyen de retenue est prévu pour un joint d'étanchéité (45), dans lequel le moyen de retenue prévu dans au moins une quelconque de la paroi latérale de la chambre de travail, et au moins un canal est prévu pour l'extraction du gaz de la chambre de travail,
dans lequel la première paroi latérale et la seconde paroi latérale de la chambre de travail sont capables de se déplacer relativement l'une à l'autre, dans lequel le joint d'étanchéité (45)est prévue entre la première paroi latérale et la seconde paroi latérale, dans lequel dans une première position relative la chambre de travail (15) est fermée et évacuée ou une atmosphère de gaz est établie à l'intérieur de celle-ci, dans lequel lorsque la première paroi latérale et la seconde paroi latérale se déplacent en une seconde position relative les matériaux à l'intérieur de la chambre de travail sont amenés en contact l'un avec l'autre.

7. Dispositif selon la revendication 6, dans lequel à l'intérieur de la chambre de travail des moyens sont prévus pour saisir la plaque de base quand la plaque de base se libère du moyen qui la retient.

8. Dispositif selon la revendication 6, dans lequel le joint d'étanchéité (45) est fixé de manière interchangeable avec le moyen de retenue.
